# FASCICULE DE BREVET EUROPEEN

(11) **EP 3 622 560 B1**
(45) Date de publication et mention de la délivrance du brevet: **23.06.2021**
(21) Numéro de dépôt: 18732140.1
(22) Date de dépôt: 09.05.2018
(51) Int. Cl.: H01L 31/048, H01L 51/44, H01L 23/29, G01N 25/48

(54) **PROCÉDÉ DE DÉTERMINATION D'UN RETARD DE CRISTALLISATION D'UN POLYMÈRE THERMOPLASTIQUE, UTILISATION D'UN TEL POLYMÈRE POUR REVÊTIR OU ENCAPSULER UN COMPOSANT ÉLECTRONIQUE ET PROCÉDÉ ASSOCIÉ**
VERFAHREN ZUR BESTIMMUNG EINER VERZÖGERUNG BEI DER KRISTALLISATION EINES THERMOPLASTISCHEN POLYMERS, VERWENDUNG EINES DERARTIGEN POLYMERS ZUR BESCHICHTUNG ODER VERKAPSELUNG EINES ELEKTRONISCHEN BAUTEILS UND ZUGEHÖRIGES VERFAHREN
METHOD FOR DETERMINING A DELAY IN THE CRYSTALLISATION OF A THERMOPLASTIC POLYMER, USE OF SUCH A POLYMER FOR COATING OR ENCAPSULATING AN ELECTRONIC COMPONENT, AND ASSOCIATED METHOD

(30) Priorité: 09.05.2017 FR 1754056
(43) Date de publication de la demande: 18.03.2020
(73) Titulaire: Commissariat à l'énergie atomique et aux énergies alternatives, 75015 Paris (FR); Arkema France, 92700 Colombes (FR)
(72) Inventeur: MATHERON, Muriel, 73000 Chambery (FR); HIDALGO, Manuel, 69530 Brignais (FR); VITE, Marion, 73000 Chambery (FR)
(74) Mandataire: Brevalex
(86) Numéro de dépôt international: PCT/FR2018/051152
(87) Numéro de publication internationale: WO 2018/206897

(56) Documents cités:
- FR-A1- 2 373 385
- US-A1- 2011 088 777
- US-A1- 2011 091 707
- US-A1- 2015 145 168
- Varun Ratta: "Chapter 8 - Crystallization and Multiple Melting Behavior of a New Semicrystalline Polyimide based on 1,3-bis (4-aminophenoxy) benzene (TPER) and 3,3', 4,4'-benzophenonetetracarboxylic dianhydride (BTDA)", CRYSTALLIZATION, MORPHOLOGY, THERMAL STABILITY AND ADHESIVE PROPERTIES OF NOVEL HIGH PERFORMANCE SEMICRYSTALLINE POLYIMIDES, 1 avril 1999 (1999-04-01), pages 243-291, XP055425945, Blackburg, Virginia Extrait de l'Internet: URL:https://theses.lib.vt.edu/theses/avail able/etd-051799-162256/unrestricted/polyim ide8.pdf [extrait le 2017-11-16]

## Description

### DOMAINE TECHNIQUE

La présente demande se rapporte à un procédé de détermination d'un retard de cristallisation d'un polymère thermoplastique semi-cristallin ainsi qu'à l'utilisation d'un polymère thermoplastique présentant un tel retard à la cristallisation pour le revêtement ou l'encapsulation d'au moins un composant électronique ou optoélectronique.

La présente demande se rapporte également à un procédé de revêtement ou d'encapsulation d'un ou de plusieurs composants électroniques ou optoélectroniques, en particulier entre deux films barrières aux gaz et/ou aux UV.

La présente demande vise notamment le revêtement ou l'encapsulation de cellules photovoltaïques et, plus particulièrement, le revêtement ou l'encapsulation de cellules photovoltaïques qui se dégradent à des températures de 130°C, voire inférieures, comme les cellules photovoltaïques à couches actives minces, par exemple les cellules photovoltaïques organiques, les cellules photovoltaïques à pérovskites et les cellules photovoltaïques à base de semi-conducteurs, ou encore comme les cellules photovoltaïques en tandem à base de pérovskites.

La présente demande se rapporte également à un assemblage comprenant de telles cellules photovoltaïques, ainsi qu'à un module photovoltaïque comprenant un tel assemblage.

La présente demande se rapporte enfin à un procédé de fabrication d'un tel module photovoltaïque, ce procédé mettant en œuvre le procédé de revêtement ou d'encapsulation précité.

### ÉTAT DE LA TECHNIQUE ANTÉRIEURE

De manière classique, un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux.

Dans le cas des modules photovoltaïques dans lesquels les cellules photovoltaïques sont en silicium cristallin, cette première couche est traditionnellement formée par une plaque de verre, présentant une épaisseur typiquement comprise entre 2 mm et 4 mm, notamment de l'ordre de 3 mm.

Dans le cas des modules photovoltaïques dits "flexibles", dont ceux dans lesquels les cellules photovoltaïques sont constituées par des cellules photovoltaïques à couches actives minces, cette première couche, qui peut être formée par une plaque de verre présentant une épaisseur de 1 mm typiquement, se présente plus souvent sous la forme d'une feuille de plastique transparente, par exemple en poly(téréphtalate d'éthylène) (PET) ou en poly(naphtalate d'éthylène) (PEN), dont l'épaisseur est comprise entre 25 µm et 250 µm et, de préférence, entre 50 µm et 175 µm.

Dans le cas des modules photovoltaïques dits "non flexibles" dans lesquels les cellules photovoltaïques sont formées par des cellules photovoltaïques à couches actives minces ou par des cellules photovoltaïques en tandem à base de pérovskites, cette première couche peut être formée par une plaque en verre d'une épaisseur de typiquement 1 mm.

Dans le cas des modules photovoltaïques à cellules photovoltaïques en silicium cristallin, la deuxième couche formant la face arrière du module photovoltaïque peut être à base de verre, de métal ou de plastique. Elle est souvent formée par une structure polymérique à base d'un polymère isolant électrique, par exemple du type PET ou polyamide (PA), cette structure pouvant être protégée par une ou plusieurs couches de quelques dizaines de microns d'épaisseur et à base de polymère fluoré, comme le poly(fluorure de vinyle) (PVF) ou le poly(fluorure de vinylidène) (PVDF).

Dans le cas des modules photovoltaïques flexibles, la deuxième couche formant la face arrière du module photovoltaïque peut être constituée d'une feuille polymérique flexible, transparente ou non, ayant une épaisseur comprise entre 25 µm et 250 µm et, de préférence, entre 50 µm et 175 µm. Toutefois, d'autres matériaux, comme le verre ou des feuilles polymériques plus épaisses, sont envisageables, ce qui aura pour effet de diminuer la flexibilité de ces modules, mais également d'augmenter la solidité mécanique de l'ensemble, voire sa capacité à résister aux contraintes environnementales, telles que la pénétration de la vapeur d'eau et de l'oxygène.

Les cellules photovoltaïques peuvent être reliées entre elles par des éléments de contact électrique avant et arrière, respectivement disposés contre les faces avant (faces se trouvant en regard de la face avant du module photovoltaïque qui est destinée à recevoir un flux lumineux) et arrière (faces se trouvant en regard de la face arrière du module photovoltaïque) de chacune des cellules photovoltaïques.

Les cellules photovoltaïques à couches actives minces, en particulier les cellules photovoltaïques organiques et à pérovskites ainsi que les cellules photovoltaïques en tandem à base de pérovskites sont particulièrement sensibles à l'humidité, à l'oxygène ainsi qu'aux rayonnements ultraviolets (UV).

Aussi, pour prolonger leur durée de vie, on procède à une étape complémentaire d'encapsulation, par exemple par laminage, desdites cellules photovoltaïques entre deux films barrières aux gaz, notamment barrières à la vapeur d'eau et au dioxygène, ces films possédant, en outre, un filtre UV. Une telle étape d'encapsulation est notamment envisagée pour tout type de dispositif optoélectronique flexible pour lesquels on utilise des films barrières aux gaz, minces et à base de polymères.

La prolongation de la durée de vie des cellules photovoltaïques ainsi encapsulées et, partant de la durée de vie des modules photovoltaïques les comprenant, dépend non seulement du choix des matériaux utilisés pour réaliser l'encapsulation, tels que les matériaux choisis pour former les films barrières et/ou pour réaliser le collage de ces films barrières sur les cellules photovoltaïques, mais également de la qualité de l'encapsulation proprement dite. En particulier, les matériaux utilisés pour réaliser l'encapsulation des cellules photovoltaïques doivent être dépourvus de défauts et notamment ne pas présenter de bulles d'air, de telle manière qu'un cheminement des gaz (vapeur d'eau, dioxygène) ne puisse pas s'opérer au travers de l'encapsulation ou le long des éléments de contact électrique. De surcroît, l'adhésion des films barrières sur les cellules photovoltaïques doit être telle qu'elle empêche tout cheminement de ces mêmes gaz au niveau des surfaces de contact, ou interfaces, que ce soit entre les films barrières et les matériaux de collage, entre les matériaux utilisés pour le collage et les cellules photovoltaïques, ou entre les éléments de contact électrique et les matériaux utilisés pour le collage.

Le collage des films barrières sur les cellules photovoltaïques est classiquement effectué en utilisant différents matériaux, ci-après dénommés "colles" ou "encapsulants". Ces termes "colle(s)" et "encapsulant(s)" seront indifféremment employés dans la suite de la présente description.

Le document US 2011/0036623, référencé [1] ci-après dans la présente description, fait un état des lieux des différents types de colles susceptibles d'être mises en œuvre pour réaliser l'adhésion des films barrières sur les cellules photovoltaïques et, plus généralement, sur des composants électroniques ou optoélectroniques, que l'on désignera ci-après par l'expression de "composant(s) (opto)électronique(s)".

Parmi les solutions proposées, on peut notamment citer les colles liquides thermo-réticulables ou photo-réticulables pour lesquelles la réticulation est respectivement obtenue par voie thermique ou par application de rayonnements UV.

Toutefois, la mise en œuvre de la voie thermique à des températures élevées n'est pas compatible avec tous les types de composants (opto)électroniques, certains pouvant se dégrader sous l'effet de températures élevées. De la même manière, l'application de rayonnements UV, bien qu'offrant la possibilité de travailler à des températures moins élevées, peut également dégrader certains composants (opto)électroniques.

Il a également été proposé d'utiliser des colles adhésives sensibles à la pression. Toutefois, pour obtenir un collage sans défaut, il peut s'avérer nécessaire de recourir à des pressions et/ou à des températures de mise en œuvre qui peuvent avoir également pour effet de dégrader certains composants (opto)électroniques.

Pour remédier aux inconvénients précités, le document **[1]** propose un procédé d'encapsulation d'un composant (opto)électronique comprenant une étape d'application, sur les parties du composant devant être encapsulées, d'une composition comprenant une colle adhésive thermofusible au moins partiellement réticulée et à base de copolymères à blocs vinylaromatiques modifiés par un acide ou par un anhydride d'acide, cette colle étant solubilisée dans un solvant approprié, tel que le toluène ou des mélanges d'essence minérale avec de l'acétone.

Le procédé décrit dans le document **[1]** met donc en œuvre un nombre non négligeable d'étapes additionnelles, en particulier une étape de mise en solution de la colle adhésive thermofusible dans le solvant organique ainsi qu'une étape d'évaporation ultérieure de ce solvant. En plus des risques de dégradation des composants (opto)électroniques au contact de ces solvants organiques, la mise en œuvre, le stockage ainsi que le retraitement de ces derniers peuvent également poser des problèmes de sécurité industrielle et de sécurité environnementale.

D'autres procédés d'encapsulation de cellules photovoltaïques, au moyen de colles ne mettant pas en œuvre de solvants organiques, ont été plus récemment décrits. Dans les publications rapportées ci-après, la colle est formée par un film adhésif en polymère thermoplastique.

Dans la publication de L. La Notte et al. ("Influence of encapsulation materials on the optical properties and conversion efficiency of heat-sealed flexible polymer solar cells", Surface & Coatings Technology, 2014, 255, 69-73), référencée **[2],** les auteurs décrivent l'utilisation de films adhésifs en copolymère éthylène-acétate de vinyle (EVA), en polyuréthane thermoplastique (TPU) ou en poly(butyral de vinyle) (PVB) pour l'encapsulation de cellules photovoltaïques organiques. Des assemblages multicouches comprenant successivement un film de PVB, un film barrière, une cellule photovoltaïque fictive, un film barrière et un film PVB ont été plus particulièrement étudiés, le PVB étant un polymère de grande souplesse et permettant la réalisation ultérieure de modules photovoltaïques de très grande flexibilité.

Le procédé d'encapsulation décrit dans le document **[2]** recourt à une étape de laminage à chaud et sous pression. Ce document **[2]** précise que, si la pression ne semble pas influencer les performances du procédé d'encapsulation, la température de laminage, quant à elle, constitue bien un paramètre essentiel. Cette température est indiquée comme devant toutefois ne pas être supérieure à 150°C, en particulier dans le cas où les cellules photovoltaïques à encapsuler sont organiques et que le module photovoltaïque les comprenant est doté d'une face avant en PET. De manière plus particulièrement avantageuse, le document **[2]** décrit que la température d'encapsulation doit être inférieure ou égale à 100°C pour ne pas nuire aux performances électriques des cellules.

Le document **[2]** rapporte toutefois la nécessité d'interposer le film barrière entre les cellules photovoltaïques organiques et les films adhésifs à base de polymère thermoplastique pour prévenir toute interaction dommageable entre ces cellules et le polymère thermoplastique. En outre, l'adhésion entre les cellules photovoltaïques et le film barrière est faible, le film barrière n'étant maintenu sur lesdites cellules que par le scellement des bords du dispositif.

D'autres publications décrivent un assemblage multicouche différent de celui décrit dans le document **[2],** dans lequel un film adhésif en polymère thermoplastique est interposé entre les cellules photovoltaïques organiques et les films barrières.

Parmi ces publications, on peut citer la publication de F. Yan et al. ("Semitransparent OPV modules pass environmental chamber test requirements", Solar Energy Materials & Solar Cells, 2013, 114, 214-218), référencée **[3],** ainsi que la publication récente de H.C. Weerasinghe et al. ("New barrier encapsulation and lifetime assessment of printed organic photovoltaic modules", Solar Energy Materials & Solar Cells, 2016, 155, 108-116), référencée **[4].**

Parmi les polymères susceptibles d'être utilisés pour le film adhésif, le document **[3]** décrit le polyuréthane, le PVB et l'EVA, déjà connus du document **[2],** mais envisage également l'utilisation d'un ionomère ou encore d'une polyoléfine. Le procédé d'encapsulation décrit dans le document **[3]** comprend :
(1) une étape de réalisation d'un assemblage comprenant les cellules photovoltaïques organiques, deux films barrières et deux films adhésifs interposés entre les cellules photovoltaïques organiques et les films barrières, puis
(2) une étape de laminage de l'assemblage réalisé à l'étape (1), ce laminage étant un laminage sous vide, conduit à une température de 130°C pendant une durée de 30 min.

Un des procédés d'encapsulation décrits dans le document **[4]** est également du type précité, l'étape de laminage étant également conduite à une température de 130°C et ce, dans une boîte à gants et sous une atmosphère d'azote pour maintenir une teneur en eau et en dioxygène de moins de 1 ppm.

On observe que les procédés d'encapsulation décrits dans les documents **[3]** et **[4]** mettent encore en œuvre une étape de laminage à une température de 130°C, sachant que cette température de 130°C reste encore élevée pour certaines cellules photovoltaïques telles que les cellules photovoltaïques organiques ou encore les cellules photovoltaïques à pérovskites pour lesquelles une dégradation est observable à des températures de 120°C et de 100°C, respectivement.

Ce constat reste également vrai pour d'autres composants (opto)électroniques, de manière plus générale. Parmi ces autres composants (opto)électroniques, on peut citer certains photo-détecteurs organiques, transistors organiques ou encore diodes électroluminescentes organiques.

De plus, il est à noter que l'étape de laminage décrite dans le document **[4]** est réalisée sous une atmosphère d'azote, ce qui n'est pas aisément transposable à une échelle industrielle.

Le but de l'invention est, par conséquent, de pallier les inconvénients des procédés d'encapsulation de l'art antérieur et de proposer un procédé qui permette une encapsulation de composants (opto)électroniques, et notamment de cellules photovoltaïques, à une température qui ne dégrade pas ces composants (opto)électroniques, soit à une température strictement inférieure à la température de 130°C décrite par les documents **[3]** et **[4],** cette température étant avantageusement inférieure ou égale à 120°C et, préférentiellement, comprise entre 95°C et 110°C.

Un autre but de l'invention est de proposer un procédé d'encapsulation qui puisse être mis en œuvre aisément sur le plan industriel, en ne recourant notamment pas à une étape de laminage à conduire sous atmosphère d'azote comme dans le document **[4]** et ce, dans des conditions de sécurité industrielle et de sécurité environnementale optimisées, en s'affranchissant de l'utilisation de solvants organiques comme décrit dans le document **[1]**. De manière plus générale, le procédé d'encapsulation selon l'invention doit limiter le nombre d'étapes à mettre en œuvre ainsi que les risques industriels et/ou environnementaux potentiels.

Un autre but de l'invention est de proposer un procédé d'encapsulation qui permette, de manière générale, d'assurer une excellente adhésion entre les composants (opto)électroniques et des couches de protection, telles que les films barrières mentionnés précédemment, ce procédé n'engendrant, en outre, pas d'interaction dommageable avec les composants (opto)électroniques destinés à être encapsulés, afin d'éviter un assemblage du type de celui décrit dans le document **[2].**

De ce qui précède, on comprend que le choix du matériau d'encapsulation constitue un élément essentiel du procédé d'encapsulation selon l'invention, n'importe quel matériau n'étant bien évidemment pas utilisable pour encapsuler des composants (opto)électroniques du type cellules photovoltaïques organiques, cellules photovoltaïques à pérovskites, cellules photovoltaïques à base de semi-conducteurs, cellules photovoltaïques en tandem à base de pérovskites, photo-détecteurs organiques, transistors organiques ou encore diodes électroluminescentes organiques.

Un autre but de l'invention est donc de proposer un procédé permettant de déterminer le choix d'un tel matériau d'encapsulation, ce matériau d'encapsulation étant, en l'espèce, un polymère thermoplastique spécifique tel que décrit ci-dessous.

Un autre but de l'invention est enfin de proposer un procédé qui permette, de manière encore plus générale, de revêtir au moins un composant (opto)électronique par une couche de protection, avec une excellente adhésion entre les composants (opto)électroniques et cette couche de protection.

Le document US2011091707, référencé [5], divulgue une composition thermoplastique utilisée dans l'encapsulation de modules solaires.

### EXPOSÉ DE L'INVENTION

Ces buts précédemment énoncés ainsi que d'autres encore sont atteints par une méthode selon la revendication 1, qui correspond à la méthode de l'invention.

Il est également divulgué un procédé de détermination d'un retard de cristallisation d'un polymère thermoplastique semi-cristallin, ce polymère thermoplastique semi-cristallin présentant une température de fusion T_{f1}.

Selon l'invention, le procédé comprend :
(a) une première étape de chauffe du polymère thermoplastique semi-cristallin à une température T₁ telle que T_{f1} < T₁,
(b) une étape de refroidissement du polymère thermoplastique semi-cristallin tel qu'obtenu à l'issue de l'étape (a), de la température T₁ à une température T₂ telle que T₂ < T_{f1},
(c) une deuxième étape de chauffe du polymère thermoplastique semi-cristallin tel qu'obtenu à l'issue de l'étape (b), de la température T₂ à la température T₁, et
   de manière optionnelle,
(d) au moins une répétition de l'étape (b), de la température T₁ à une température T, et de l'étape (c), de la température T à la température T₁, avec T₂ ≤ T,
   le retard de cristallisation du polymère thermoplastique semi-cristallin étant observé dès lors que le suivi par analyse calorimétrique différentielle à balayage (DSC) révèle l'absence de pic de cristallisation lors de la ou les étapes (b) et l'absence de pic de fusion lors de la ou les étapes (c) à la température T_{EF} telle que T ≤ T_{EF} ≤ T_{f1}.

Ce procédé permet donc de déterminer, de manière relativement aisée, si le polymère thermoplastique semi-cristallin testé présente, ou non, un retard de cristallisation. Dans l'affirmative, un tel polymère reste à l'état fondu à la température T_{EF} et ce, pendant un certain intervalle de temps qui correspond au retard à la cristallisation. En d'autres termes, sur cet intervalle de temps et à cette température T_{EF}, le polymère ne présente pas de phase cristalline pouvant provenir d'une cristallisation partielle ou totale. Un tel polymère peut alors être aisément transformé à la température T_{EF} telle que T ≤ T_{EF} ≤ T_{f1}.

Lors de l'étape (a), on procède à une première chauffe du polymère thermoplastique à une température T₁, cette température T₁ étant supérieure à la température de fusion T_{f1} dudit polymère. Ce faisant, on obtient la fusion de la ou des phases cristallines du polymère thermoplastique, ce dernier se trouvant alors intégralement à l'état fondu.

Bien entendu, la température T₁ appliquée doit être telle qu'elle ne dégrade pas le polymère thermoplastique.

Dans une variante avantageuse du procédé selon l'invention, la température T₁ est telle que T_{f1} + 20°C ≤ T₁ ≤ T_{f1} + 50°C.

La température de fusion T_{f1} peut notamment être déterminée à l'aide d'une première chauffe en DSC, par exemple réalisée à une vitesse de rampe de 10°C/min. La température de fusion T_{f1} correspond alors à la température du minimum du pic de fusion, selon la convention qui veut que les pics endothermiques aient un minimum, ci-après désignée par l'expression "convention endo down".

Lors de l'étape (b), on procède au refroidissement du polymère thermoplastique semi-cristallin se trouvant à l'état fondu tel qu'obtenu à l'issue de l'étape (a), de la température T₁ jusqu'à une température T₂, intervalle de températures sur lequel le suivi par DSC révèle l'absence de pic de cristallisation.

Ce refroidissement peut également être effectué à une vitesse de rampe de 10°C/min.

Lors de l'étape (c), on procède à une deuxième chauffe du polymère thermoplastique, toujours à l'état fondu à l'issue de l'étape (b), de la température T₂ à la température T₁.

Cette deuxième chauffe peut aussi être effectuée à une vitesse de rampe de 10°C/min.

Comme dans le cas de l'étape (b), cette étape (c) est suivie par une analyse DSC sur l'intervalle de températures comprises entre T₂ et T₁. Deux cas peuvent se présenter:
(1) soit le suivi par DSC révèle l'absence de pic de fusion,
(2) soit le suivi par DSC révèle la présence d'au moins un pic de fusion.

Dans le cas (1), l'absence de pic de cristallisation et de pic de fusion lors des étapes (b) et (c) atteste que le polymère thermoplastique semi-cristallin se trouve bien à l'état fondu sur l'intervalle des températures comprises entre T₂ et T₁.

Dans le cas (2), la présence d'au moins un pic de fusion lors de l'étape (c) montre que le polymère thermoplastique semi-cristallin a au moins partiellement cristallisé lors de l'étape (b) de refroidissement, bien que le suivi par DSC de cette étape (b) n'ait pas mis en évidence de pic de cristallisation.

Aussi, dans ce cas (2), le procédé selon l'invention comprend, en outre, après l'étape (c), une étape (d) telle que :
(d) au moins une répétition de l'étape (b), de la température T₁ à une température T, et de l'étape (c), de la température T à la température T₁, avec T₂ ≤ T.

Lors de l'étape (d), l'étape (b) de refroidissement est opérée de la température T₁ à une température T supérieure à T₂, tandis que l'étape (c) de chauffe est réalisée de cette température T supérieure à la température T₁, ces étapes (b) et (c) étant toujours suivies par DSC.

L'étape (d) est reconduite tant que le suivi par DSC révèle la présence d'au moins un pic de fusion lors de l'étape (c) de chauffe, jusqu'à atteindre la température T à laquelle le suivi par DSC révèle non seulement l'absence de pic de cristallisation lors de l'étape (b) mais également l'absence de pic de fusion lors de l'étape (c).

Le polymère thermoplastique semi-cristallin peut ne présenter qu'une seule température de fusion T_{f1}. L'absence de pic de cristallisation lors de l'étape (b) de refroidissement est la signature du retard à la cristallisation.

Le polymère thermoplastique semi-cristallin peut également présenter, en plus de la température de fusion T_{f1}, une ou plusieurs autres températures de fusion, étant précisé que, dans tous les cas de figures, la température T_{f1} telle que définie ci-dessus correspond à la température de fusion la plus élevée.

En particulier, le polymère thermoplastique peut présenter, en outre, une deuxième température de fusion T_{f2}, avec T_{f2} < T_{f1}, signifiant qu'il présente deux phases cristallines distinctes, l'une fondant à la température de fusion T_{f2} et l'autre fondant à la température de fusion T_{f1}.

Un refroidissement complet d'un tel polymère à deux températures de fusion et présentant un retard à la cristallisation conduit à l'observation d'un seul pic de cristallisation et non de deux, comme on pourrait s'y attendre. Ce seul pic de cristallisation peut correspondre soit à la cristallisation de l'une seule des deux phases cristallines, soit à la cristallisation concomitante des deux phases cristallines.

On peut procéder par ailleurs à l'utilisation d'un polymère thermoplastique semi-cristallin présentant un retard à la cristallisation, pour revêtir au moins un composant (opto)électronique ou pour encapsuler au moins un composant (opto)électronique, notamment entre deux films barrières aux gaz et/ou aux UV.

Le retard à la cristallisation que présente ledit polymère thermoplastique semi-cristallin peut être déterminé par le procédé de détermination d'un retard tel que défini ci-dessus, les variantes avantageuses de ce procédé étant prises seules ou en combinaison.

L'invention se rapporte au procédé qui fait l'objet de la revendication 1.

Dans ce qui précède et dans ce qui suit, on entend par procédé de revêtement, un procédé qui vise à réaliser un assemblage comprenant au moins un composant (opto)électronique sur lequel est disposée une couche de protection, l'adhésion de cette couche de protection au(x)dit(s) composant(s) étant assurée par un film adhésif comprenant au moins un polymère thermoplastique semi-cristallin présentant un retard à la cristallisation.

De la même manière, dans ce qui précède et dans ce qui suit, on entend par procédé d'encapsulation, un procédé qui vise à réaliser un assemblage comprenant au moins un composant (opto)électronique disposé entre deux couches de protection, l'adhésion de chacune des couches de protection au(x)dit(s) composant(s) étant assurée par deux films adhésifs comprenant au moins un polymère thermoplastique semi-cristallin présentant un retard à la cristallisation.

Grâce au procédé de revêtement ou d'encapsulation selon l'invention, on peut notamment obtenir un assemblage du type de celui décrit dans les documents [3] et **[4],** avec un revêtement ou une encapsulation du ou des composants (opto)électroniques qui ne présente pas de défaut du type bulles d'air, avec une adhésion améliorée, l'étape de laminage étant conduite à une température qui est inférieure à la température susceptible de dégrader le ou les composants (opto)électroniques.

En particulier, et comme cela sera illustré dans l'exemple ci-après, de telles performances d'adhésion ne peuvent pas être atteintes par un procédé de revêtement ou d'encapsulation ne comprenant pas l'étape (a) de chauffe, l'étape (b) de refroidissement et l'étape (c') de maintien en température, les autres étapes (1) et (2) étant identiques par ailleurs.

De telles performances sont atteintes grâce à la combinaison des étapes (a), (b), (c'), (1) et (2) et du polymère thermoplastique semi-cristallin particulier choisi pour former le ou les films adhésifs, ce polymère thermoplastique présentant, en effet, des propriétés thermiques et rhéologiques particulières dont les Inventeurs ont tiré profit pour le procédé de revêtement ou d'encapsulation selon l'invention.

En particulier, le polymère thermoplastique semi-cristallin choisi pour former le ou chaque film adhésif conserve un état fondu pendant toutes les étapes (a) à (c'), sur l'intervalle des températures T_{EF} comprises entre la température T₁ et la température T. En particulier, lors des étapes (b) et (c'), le polymère thermoplastique semi-cristallin conserve un état fondu sur l'intervalle de températures T_{EF} comprises entre la température T_{f1} et la température T.

Compte tenu des relations existant entre les températures T_{EF} et T₃, d'une part, et la température de dégradation T_{d} à partir de laquelle le ou les composants (opto)électroniques se dégradent, d'autre part, en l'espèce T_{EF} < T_{d} et T_{EF}<T₃ < T_{d}, le choix du polymère thermoplastique semi-cristallin pourra donc avantageusement être adapté à la température de dégradation T_{d} du composant (opto)électronique considéré.

Lorsque ce composant est un composant optoélectronique, il peut notamment être une cellule photovoltaïque, en particulier une cellule photovoltaïque dite à couches actives minces ou une cellule photovoltaïque en tandem à base de pérovskites, une diode électroluminescente organique (OLED), une diode électroluminescente à polymère (PLED) ou encore un photo-détecteur organique.

Parmi les cellules photovoltaïques à couches minces actives, on peut plus particulièrement citer les cellules photovoltaïques organiques, les cellules photovoltaïques à pérovskites ainsi que les cellules photovoltaïques à base de semi-conducteurs, notamment à base de silicium amorphe, à base de tellurure de cadmium (CdTe) ou encore à base d'alliages de cuivre, d'indium, de sélénium et, le cas échéant, de gallium (CIS et CIGS).

Parmi les cellules photovoltaïques en tandem à base de pérovskites, on peut plus particulièrement citer les cellules photovoltaïques en tandem silicium/pérovskites ou encore les cellules photovoltaïques en tandem CIGS/pérovskites.

Lorsque ce composant est un composant électronique, il peut notamment être un transistor organique, par exemple un transistor à couches minces organiques (OTFT).

Le procédé de revêtement ou d'encapsulation selon l'invention comprend une étape (a) de chauffe du ou de chaque film adhésif à une première température T₁, cette première température T₁ étant telle que T_{f1} < T₁, T_{f1} correspondant à la température de fusion de la phase cristalline, lorsque le polymère ne comprend qu'une seule phase cristalline, ou à la température de fusion la plus élevée des phases cristallines du polymère, lorsque ce polymère en comprend deux ou plus.

En portant le ou les films adhésifs à cette température T₁, qui est supérieure à la température de fusion T_{f1}, on obtient non seulement la fusion de la ou des phases cristallines du polymère thermoplastique semi-cristallin, mais on peut également adapter la viscosité du polymère de manière à la rendre compatible avec les modalités de mise en œuvre de cette étape (a), en particulier lorsque cette étape (a) de chauffe consiste en un laminage.

Dans un mode de réalisation particulier, l'étape (a) de chauffe du ou de chaque film adhésif est opérée à la température T₁ telle que T_{f1} + 20°C ≤ T₁ ≤ T_{f1} + 50°C.

Comme décrit ci-avant, T_{f1} peut être préalablement déterminée par une analyse DSC à une vitesse de rampe de 10°C/min et correspond au minimum du pic endothermique de fusion selon la convention endo down.

Comme déjà indiqué précédemment, l'étape (a) de chauffe peut être réalisée par laminage. Ce laminage est avantageusement réalisé sous une pression absolue, telle que mesurée dans le laminateur, qui est comprise entre 10 Pa et 10⁵ Pa.

Dans un premier mode de réalisation, lorsque l'étape (a) de chauffe est réalisée par laminage, le ou chaque film adhésif peut être laminé seul, le cas échéant, entre deux feuilles pelables. De telles feuilles pelables peuvent, par exemple, être en polytétrafluoroéthylène (PTFE).

Ce premier mode de réalisation présente un intérêt particulier, notamment lorsque la ou les couches de protection présentent, comme le ou les composants (opto)électroniques à protéger, des risques de dégradation à des températures supérieures ou égales à T_{d}.

Dans un second mode de réalisation, et toujours dans le cas où l'étape (a) de chauffe est réalisée par laminage, on peut procéder au laminage d'un ou de bicouches, le ou chaque bicouche étant constitué d'un film adhésif et d'une couche de protection.

Le procédé de revêtement ou d'encapsulation selon l'invention comprend, en outre, après l'étape (a) de chauffe, une étape (b) de refroidissement du ou de chaque film adhésif chauffé à l'étape (a), de la température T₁ à la température T_{EF}, cette température T_{EF} étant telle que T ≤ T_{EF} ≤ T_{f1} et T_{EF} < T_{d}.

En abaissant la température des films adhésifs de la température T₁ à cette température T_{EF} telle que T ≤ T_{EF} ≤ T_{f1}, on maintient ce polymère thermoplastique semi-cristallin, à l'état fondu, du fait du retard à la cristallisation présenté par le polymère thermoplastique semi-cristallin choisi.

Dans un mode de réalisation particulier, l'étape (b) de refroidissement du ou de chaque film adhésif est effectuée à une température T_{EF} telle que T ≤ T_{EF} ≤ T_{f1} -10°C, T_{f1} étant avantageusement déterminée comme décrit ci-dessus.

Le procédé de revêtement ou d'encapsulation selon l'invention comprend, en outre, après l'étape (b) de refroidissement, une étape (c') de maintien du ou de chaque film adhésif refroidi à cette température T à laquelle le polymère thermoplastique semi-cristallin du ou de chaque film adhésif reste à l'état fondu.

Dans un mode de réalisation particulier, l'étape (c') de maintien à la température T du ou de chaque film adhésif est effectuée à une température T_{EF} telle que T ≤ T_{EF} ≤ T_{f1} -10°C.

Le polymère thermoplastique du ou de chaque film adhésif peut conserver cet état fondu pendant un certain temps t.

Dans un mode de réalisation particulier, ce temps t de maintien à l'état fondu peut être compris entre 5 min et 5 h, avantageusement, entre 10 min et 4 h et, préférentiellement, entre 15 min et 3 h.

Le procédé de revêtement ou d'encapsulation selon l'invention comprend, après l'étape (c') de maintien à la température T_{EF}, une étape (1) de réalisation d'un assemblage comprenant un ou plusieurs composants (opto)électroniques, la ou les couches de protection et le ou les films adhésifs en polymère thermoplastique, ce ou ces films adhésifs étant interposés entre le ou les composants (opto)électroniques et la ou les couches de protection, étant précisé que cette étape (1) est réalisée à une température T₃ telle que T_{EF}<T₃ T_{d}, soit à une température supérieure à la température T_{EF} pour tirer bénéfice de l'état fondu présenté par le polymère thermoplastique semi-cristallin du ou de chaque film adhésif.

Lors de cette étape (1), on procède à l'empilement des différents éléments formant l'assemblage qui peut notamment présenter la structure multicouche suivante : couche de protection/film adhésif/composant(s) (opto)électronique(s)/film adhésif/couche protection.

Dans un mode de réalisation de l'invention, l'épaisseur du ou de chaque film adhésif est inférieure ou égale à 500 µm et, avantageusement, comprise entre 50 µm et 200 µm.

Dans un mode de réalisation de l'invention, la ou les couches de protection peuvent être choisies parmi des couches de renfort mécanique et des films barrières.

Les couches de renfort mécanique peuvent notamment être formées par une feuille ou par une plaque de divers matériaux, tels que du verre, du métal ou un matériau polymérique. De telles couches peuvent éventuellement présenter des propriétés barrières, notamment aux gaz et/ou aux UV.

Pour optimiser la résistance des assemblages aux intempéries, et notamment leur résistance aux gaz et/ou aux UV, on préfèrera mettre en œuvre, comme couches de protection, des films barrières, en particulier des films barrières aux gaz et/ou aux UV.

Les films barrières aux gaz et/ou aux UV sont généralement formés par des films multicouches.

Des exemples de tels films multicouches convenant pour la réalisation de films barrières aux gaz et/ou aux UV sont notamment disponibles auprès de la Société Oïke, sous la dénomination commerciale VX-25T-2PO, ou encore auprès de la Société 3M, sous la dénomination commerciale UBF510.

On peut également tout à fait envisager un assemblage comprenant une couche de renfort mécanique et un film barrière.

On peut également envisager de réaliser, soit un assemblage constitué par un ou plusieurs composants (opto)électroniques revêtus d'un seul film adhésif, soit un assemblage constitué par un ou plusieurs composants (opto)électroniques revêtus de part et d'autre de deux films adhésifs, ces assemblages distincts étant tous deux dépourvus de couche de protection.

Dans un mode de réalisation particulier de l'invention, l'épaisseur du ou de chaque film barrière est inférieure ou égale à 500 µm et, avantageusement, comprise entre 50 µm et 250 µm.

Lors de cette étape (1), et dans le cas où l'étape (a) de chauffe est réalisée par laminage selon le premier mode de réalisation dans lequel le ou chaque film adhésif est laminé seul, on dispose, après retrait des feuilles pelables lorsqu'elles sont présentes, tout d'abord le ou chaque film adhésif laminé de part et d'autre du ou des composants (opto)électroniques, puis la ou chaque couche de protection sur le ou chaque film adhésif.

Lors de cette étape (1), et dans le cas où l'étape (a) de chauffe est réalisée par laminage selon le second mode de réalisation dans lequel on procède au laminage d'un ou de bicouches, le ou chaque bicouche étant constitué d'un film adhésif et d'une couche de protection, on dispose le ou chaque bicouche de part et d'autre du ou des composants (opto)électroniques de telle sorte que le ou chaque film adhésif du ou des bicouches soit en contact avec le ou les composants (opto)électroniques.

Il est également tout à fait envisageable de réaliser l'étape (1) en combinant les deux dispositions ci-dessus.

On peut ainsi et successivement disposer, sur un bicouche obtenu selon le second mode de réalisation, le ou les composants (opto)électroniques, puis un film adhésif obtenu selon le premier mode de réalisation et enfin une couche de protection.

Cette étape (1) aboutissant à la constitution de l'assemblage multicouche décrit ci-dessus peut être réalisée à la température T_{EF} atteinte à la fin de l'étape (b) de refroidissement et maintenue lors de l'étape (c'). Cette étape (1) est donc réalisée à une température à laquelle le polymère thermoplastique semi-cristallin du ou des films adhésifs est toujours à l'état fondu et qui n'engendre aucun risque de dégradation du ou des composants (opto)électroniques présents dans l'assemblage, étant donné que T_{EF} < T_{d}.

L'étape (1) de réalisation de l'assemblage est effectuée à une température T₃ telle que T_{EF} < T₃ < T_{d}.

Le procédé de revêtement ou d'encapsulation selon l'invention comprend, après l'étape (1) de réalisation de l'assemblage décrit ci-dessus, une étape (2) de laminage de cet assemblage, cette étape (2) étant réalisée à une température T_{3'} telle que T_{EF} < T₃ ≤ T_{3'} < T_{D}.

Les étapes (1) de réalisation de l'assemblage et (2) de laminage de cet assemblage peuvent être réalisées à une même valeur de température T₃ (T_{3'} = T₃) telle que T_{EF} < T₃ < T_{d}.

Toutefois, cette température T₃ s'inscrivant dans un intervalle de températures, la température T₃ mise en œuvre lors de l'étape (1) de réalisation de l'assemblage peut ne pas être nécessairement identique à la température T_{3'} mise en œuvre lors de l'étape (2) de laminage de cet assemblage. En particulier, et comme on le verra dans le chapitre relatif à l'exposé détaillé de modes de réalisation particuliers, la température T_{3'} mise en œuvre lors de l'étape (2) de laminage de l'assemblage peut être un peu supérieure à la température T₃ mise en œuvre lors de l'étape (1) de réalisation de cet assemblage.

Cette température T₃, comme la température T_{EF}, maintient à l'état fondu le polymère thermoplastique semi-cristallin du ou des films adhésifs et préserve le ou les composants (opto)électroniques de tout risque de dégradation.

Dans un mode de réalisation particulier, l'étape (2) de laminage peut être effectuée à une température T₃ un peu supérieure à la température T_{EF}, par exemple telle que T_{EF} + 5°C ≤ T₃ < T_{d}.

Ce laminage de l'étape (2) est avantageusement réalisé sous une pression absolue, telle que mesurée dans le laminateur, qui est comprise entre 10 Pa et 10⁵ Pa.

Dans le procédé selon l'invention, le polymère thermoplastique semi-cristallin du ou de chaque film adhésif est un polymère greffé polyamide comprenant un tronc en polyoléfine, représentant de 50% à 95% en masse du polymère greffé polyamide, un reste d'au moins un monomère insaturé (X) et au moins un greffon en polyamide, le reste d'au moins un monomère insaturé (X) et le ou les greffons en polyamide représentant de 5% à 50% en masse dudit polymère greffé polyamide, dans lequel :
- le ou les greffons en polyamide sont attachés au tronc en polyoléfine par le reste d'au moins un monomère insaturé (X) comprenant une fonction capable de réagir par une réaction de condensation avec un polyamide ayant au moins une extrémité amine et/ou au moins une extrémité acide carboxylique,
- le reste d'au moins un monomère insaturé (X) est fixé sur le tronc par greffage ou copolymérisation,
- le tronc en polyoléfine et le ou les greffons en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion mesurées au pic de DSC et les températures de transition vitreuse du ou des greffons en polyamide et du tronc en polyoléfine.

De tels polymères thermoplastiques semi-cristallins sont, par exemple, décrits dans le document US 2011/0091707, référencé **[5]**.

Dans une variante de l'invention, la polyoléfine du tronc en polyoléfine peut être choisie parmi le polypropylène, le polyéthylène, les copolymères d'éthylène et de propylène et les copolymères d'éthylène avec des monomères acryliques ou vinyliques.

Dans une variante de l'invention, le monomère insaturé (X) peut être choisi parmi l'anhydride maléique, l'anhydride itaconique, l'anhydride citraconique et l'anhydride allylsuccinique.

Dans une variante de l'invention, le polyamide peut être choisi parmi les homopolyamides, les copolyamides et leurs mélanges, en particulier parmi les homopolyamides et les copolyamides à une seule terminaison amine.

De préférence, un tel polymère greffé polyamide comprend de 15 à 30% en masse du reste d'au moins un monomère insaturé (X) et du ou des greffons en polyamide.

La masse molaire en nombre du ou des greffons en polyamide est avantageusement comprise dans la gamme allant de 1000 g/mol à 5000 g/mol, de préférence comprise dans la gamme allant de 2000 g/mol à 3000 g/mol. Le ou les greffons en polyamide peuvent comprendre au moins un copolyamide. Avantageusement, les extrémités du ou des greffons en polyamide sont une ou des fonctions amine.

Le tronc en polyoléfine peut ne pas présenter de température de fusion ou, en alternative, présenter une température de fusion inférieure ou égale à 100°C. De préférence, le nombre de monomères (X) fixés sur le tronc en polyoléfine est supérieur ou égal à 1,3 et/ou inférieur ou égal à 10. Avantageusement, le monomère insaturé (X) est l'anhydride maléique. Le tronc en polyoléfine du polymère thermoplastique peut être un copolymère comprenant un monomère insaturé (X), par exemple un copolymère éthylène-(méth)acrylate d'alkyle comprenant un monomère insaturé (X).

Avantageusement, la température d'écoulement dudit polymère greffé polyamide est comprise dans la gamme allant de 70°C à 160°C, avantageusement de 75°C à 135°C et, préférentiellement, de 85°C à 130°C.

Outre le polymère thermoplastique semi-cristallin décrit ci-dessus, le film adhésif peut également comprendre une résine tackifiante ainsi que, le cas échéant, un polymère complémentaire, de préférence miscible ou partiellement miscible avec le polymère greffé polyamide.

Généralement, le film adhésif comprend au moins 75% en masse de polymère greffé polyamide. Il peut par ailleurs comprendre, en outre, au moins un des composants additionnels choisis parmi les agents réticulants, les absorbants UV, les charges minérales, les diluants, les plastifiants, les matières colorantes, les azurants optiques et les agents ignifugeants.

De préférence, un film adhésif comprenant un tel polymère greffé polyamide d'une épaisseur de 500 µm transmet une onde électromagnétique d'une longueur d'onde allant de 400 nm à 700 nm à au moins 80% et/ou présente un niveau de trouble inférieur ou égal à 10%, la transmission et le niveau de trouble du film étant mesurés selon la norme ASTM D1003.

Dans cette variante particulièrement avantageuse du procédé selon l'invention, le polymère greffé polyamide présente deux températures de fusion T_{f1} et T_{f2}, avec T_{f2} < T_{f1}, T_{f1} et T_{f2} correspondant respectivement à la température de fusion de la phase cristalline polyamide et à la température de fusion de la phase cristalline polyoléfine.

Des polymères thermoplastiques semi-cristallins répondant à la définition de polymère greffé polyamide telle que définie ci-dessus sont disponibles, auprès de la société Arkema, sous la dénomination commerciale "Apolhya® Solar".

Dans le procédé de l'invention, les différentes températures mises en œuvre dans le procédé selon l'invention sont les suivantes :
- la température T₁, qui est mise en œuvre lors de l'étape (a) de chauffe du ou de chaque film adhésif, est comprise entre 150°C et 175°C et, préférentiellement, entre 160°C et 170°C. Ce faisant, les deux phases cristallines polyamide et polyoléfine ont fondu et la viscosité est adaptée à un laminage ;
- la température T_{EF}, qui est mise en œuvre lors de l'étape (b) de refroidissement du ou de chaque film adhésif, lors de l'étape (c') de maintien à la température T_{EF} du ou de chaque film adhésif ainsi que lors de l'étape (1) de réalisation de l'assemblage, est comprise entre 95°C et 120°C et, préférentiellement, entre 100°C et 110°C, et
- les températures T₃ et T_{3'}, qui sont mises en oeuvre lors des étapes (1) et (2), sont comprises entre 100°C et 130°C et, préférentiellement, entre 110°C et 120°C.

Compte tenu de l'intervalle de températures dans lequel s'inscrit la température T₃, il devient parfaitement envisageable de procéder au revêtement ou à l'encapsulation d'un grand nombre de composants électroniques ou optoélectroniques, dont ceux déjà mentionnés ci-dessus (cellule photovoltaïque, diode du type OLED ou PLED, photo-détecteur organique, transistor organique, par exemple du type OTFT), mais également d'autres composants électroniques ou optoélectroniques qui se dégradent à des températures de 130°C, voire inférieures, tels qu'une cellule photovoltaïque du type cellule photovoltaïque organique, cellule photovoltaïque à pérovskites, cellule photovoltaïque à base de semi-conducteurs ou encore cellule photovoltaïque en tandem à base de pérovskites.

Un exemple particulier de film adhésif en un polymère thermoplastique semi-cristallin répondant à la définition précédente est disponible auprès de la Société Arkema France, sous la dénomination commerciale Apolhya®Solar Film R333D. Un tel film adhésif, transparent et présentant une épaisseur de 100 µm, est formé par un copolymère polyoléfinique comprenant des greffons polyamide, couramment noté polyoléfine-g-polyamide.

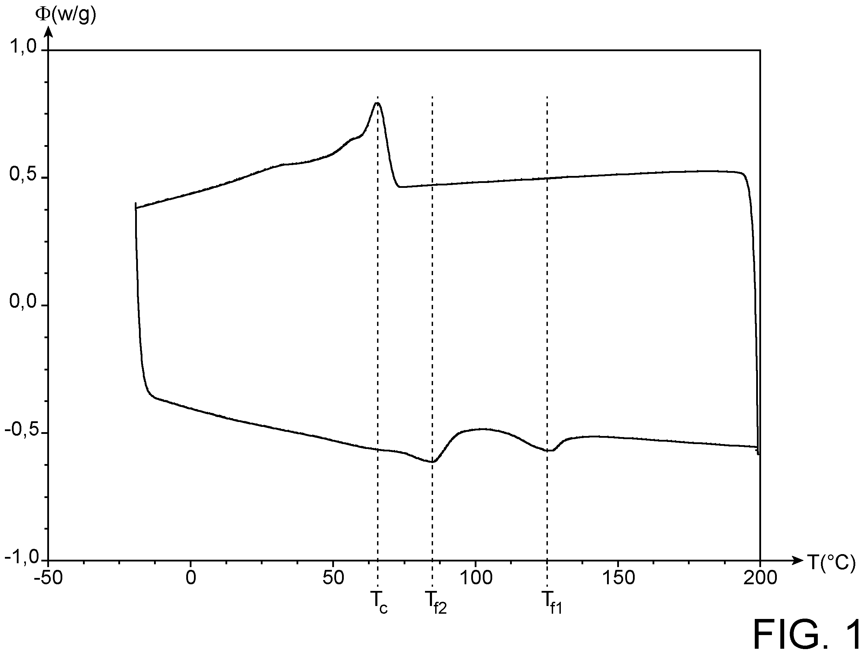

Le thermogramme, tel qu'obtenu par DSC et reproduit à la figure 1, illustre l'évolution du flux de chaleur, en fonction de la température, de films adhésifs d'Apolhya®Solar Film R333D, en première chauffe puis en refroidissement, pour des rampes de chauffe et de refroidissement identiques de 10°C/min.

Une première étape (a) de chauffe d'une température initiale inférieure à -25°C jusqu'à une température de 200°C met en évidence deux pics de fusion distincts, le minimum de chacun des deux pics étant repérés, sur la figure 1 et conformément à la convention endo down, à une température de fusion T_{f2} = 85°C pour la fusion de la phase cristalline polyoléfine et à une température de fusion T_{f1} = 125°C pour la fusion de la phase cristalline polyamide.

À partir de la connaissance de ces valeurs de températures de fusion T_{f1} et T_{f2}, on peut donc raisonnablement considérer qu'une étape (a) de chauffe de ces films adhésifs d'Apolhya®Solar Film R333D à une température T₁ de 150°C permet non seulement d'obtenir la fusion totale des deux phases cristallines du polymère formant ces films adhésifs d'Apolhya®Solar Film R333D mais également d'atteindre une viscosité qui est compatible avec une mise en œuvre par laminage, avantageusement par un laminage réalisé sous une pression absolue comprise entre 10 Pa et 10⁵ Pa.

Toutefois, si une telle température de 150°C est parfaitement envisageable pour le revêtement ou l'encapsulation, par laminage, de cellules photovoltaïques en silicium (cellules c-Si), elle ne l'est pas pour le revêtement ou l'encapsulation de composants optoélectroniques du type cellules photovoltaïques à couches minces actives telles que les cellules photovoltaïques organiques, les cellules photovoltaïques à pérovskites et les cellules photovoltaïques à base de semi-conducteurs, ou encore du type cellules photovoltaïques en tandem à base de pérovskites, ces composants optoélectroniques se dégradant respectivement à partir de 120°C et 100°C.

On procède ensuite, lors de l'analyse par DSC, à une étape (b) de refroidissement complet des films d'Apolhya®Solar Film R333D depuis la température de 200°C atteinte lors de l'étape (a) de première chauffe jusqu'à la température initiale inférieure à -25°C.

On pourrait s'attendre à ce que, lors de ce refroidissement, soient observés deux pics de cristallisation, repérés à deux températures distinctes et correspondant à la cristallisation de chacune des deux phases cristallines polyamide et polyoléfine de ce polymère.

Or, ce refroidissement complet conduit à l'observation d'un seul pic de cristallisation, repéré au niveau de son maximum à la température T_{c} de 65°C. Ce pic de cristallisation, qui correspond à la cristallisation de la phase polyoléfine du polymère, apparaît donc à une température inférieure aux deux températures de fusion T_{f1} et T_{f2} des deux phases cristallines présentes dans le polymère thermoplastique semi-cristallin. La présence de ce seul pic de cristallisation est la signature d'un retard à la cristallisation de l'une des deux phases cristallines du polymère, en l'occurrence la phase cristalline polyamide dont le pic de fusion en chauffe se trouvait à 125°C (T_{f1}).

Ce retard de cristallisation permet au polymère du film d'Apolhya®Solar Film R333D de conserver un état fondu au moins jusqu'à atteindre la valeur de 75°C, qui correspond à la température à partir de laquelle on repère, lors de l'étape (b) de refroidissement illustrée sur la figure 1, le début du pic de cristallisation et, partant, le début de la cristallisation de la phase cristalline polyoléfine.

Toutefois, le suivi par DSC d'une deuxième chauffe du film d'Apolhya®Solar Film R333D de la température de 60°C à la température de 200°C fait apparaître deux pics de fusion, traduisant que la cristallisation partielle des deux phases cristallines du polymère s'est produite.

En conséquence, il a été procédé à la mise en œuvre de plusieurs étapes (d) de répétition des étapes (b) de chauffe et (c) de refroidissement, à des températures T successives de 70°C, 80°C, 90°C et 100°C.

Le suivi DSC de l'étape (b) de chauffe mise en œuvre lors de la quatrième étape (d), de la température T de 100°C à 200°C, n'a révélé la présence d'aucun pic de fusion, signifiant que le polymère se trouve bien à l'état fondu, sans cristallisation partielle de l'une ou de ses deux phases cristallines, sur l'intervalle de températures comprises entre 100°C et 200°C et, avantageusement, entre 100°C et 110°C, ces dernières températures étant bien inférieures à T_{f1}.

Ce comportement thermique particulier permet d'envisager très favorablement la mise en œuvre de ces films adhésifs d'Apolhya®Solar Film R333D pour revêtir ou encapsuler un ou des composants (opto)électroniques qui se dégradent à des températures de 130°C ou plus, par exemple des composants du type cellules photovoltaïques à couches minces actives ou encore cellules photovoltaïques en tandem à base de pérovskites.

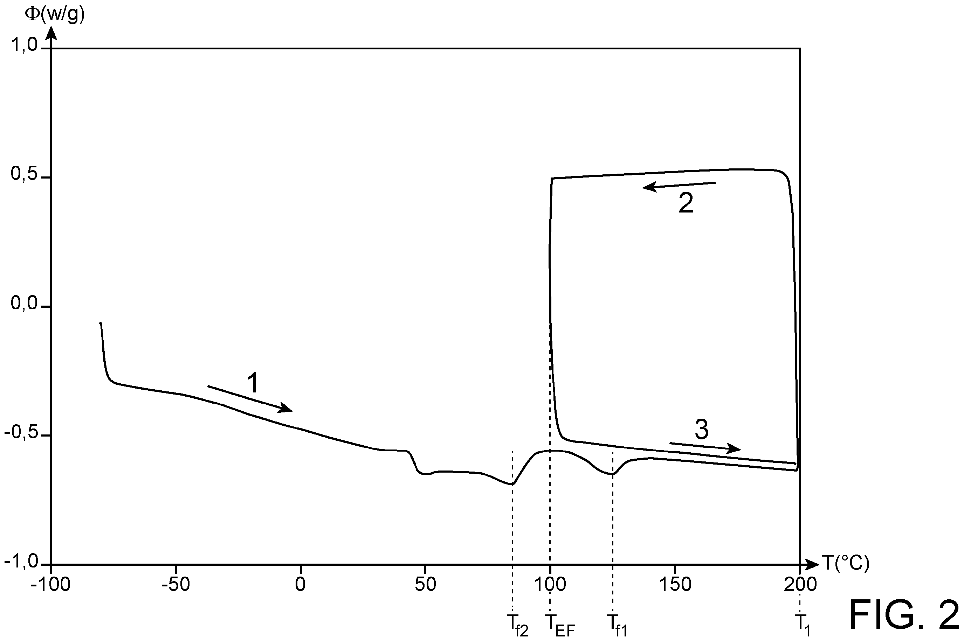

Le thermogramme, tel qu'obtenu par DSC et reproduit à la figure 2, illustre l'évolution du flux de chaleur, en fonction de la température, de films adhésifs d'Apolhya®Solar Film R333D, en première chauffe (a), puis en refroidissement partiel (b) et enfin en deuxième chauffe (c), pour des rampes de chauffe et de refroidissement identiques de 10°C/min.

L'étape (a) de première chauffe correspond à la courbe repérée par la flèche 1 sur la figure 2. Cette première chauffe, qui est conduite d'une température initiale inférieure à -25°C jusqu'à une température de 200°C, met en évidence les deux pics de fusion déjà repérés sur la figure 1, avec T_{f2} = 85°C et T_{f1} = 125°C.

L'étape (b) de refroidissement partiel des films d'Apolhya®Solar Film R333D correspond à la courbe repérée par la flèche 2 sur la figure 2. Ce refroidissement est conduit depuis la température de 200°C atteinte lors de la première chauffe (a) jusqu'à une température T_{EF}, de l'ordre de 100°C, qui n'atteint pas la température T_{c} de 65°C à laquelle se présente le maximum du seul pic de cristallisation repéré sur la figure 1 lors du refroidissement complet.

Cette courbe repérée par la flèche 2 est une courbe plate, traduisant l'absence de pic de cristallisation sur tout l'intervalle de températures T_{EF} comprises entre 200°C et 100°C.

L'étape (c) de deuxième chauffe correspond à la courbe repérée par la flèche 3 sur la figure 2. Cette deuxième chauffe est conduite de la température T_{EF} de 100°C, jusqu'à une température de 200°C. La courbe correspondante obtenue et repérée par la flèche 3 est également une courbe plate, traduisant l'absence de pic de fusion sur tout l'intervalle de températures comprises entre 100°C (T_{EF}) et 200°C, en particulier à la température de 125°C, qui correspondait au pic de fusion le plus élevé repéré lors de l'étape (a) de première chauffe (flèche 1). Ce constat met en évidence le fait que la phase cristalline polyamide, qui a fondu à T_{f1} lors de la première chauffe (a), n'a absolument pas cristallisé lors de l'étape (b) de refroidissement partiel.

En conséquence, sur l'intervalle de températures comprises entre 100°C et 200°C, le polymère thermoplastique semi-cristallin du film d'Apolhya®Solar Film R333D se trouve intégralement à l'état fondu. On entend par le terme "fondu", un état du polymère semi-cristallin dans lequel la totalité de ses phases cristallines a fondu, même si, s'agissant d'un polymère et, en particulier, d'un polymère greffé, on n'obtient pas forcément un liquide mais plutôt, et de manière préférée, un matériau à l'aspect d'un solide mou.

Dans un mode de réalisation particulier dans lequel le ou les films adhésifs sont constitués par des films d'Apolhya®Solar Film R333D, le procédé de revêtement ou d'encapsulation comprend les étapes successives suivantes :
(a) une étape de chauffe du ou des films adhésifs à une température T₁ de 150°C,
(b) une étape de refroidissement de ce ou ces films adhésifs ainsi chauffés de 150°C (T₁) jusqu'à une température T_{EF} de l'ordre de 100°C,
(c') une étape de maintien du ou de chaque film adhésif refroidi à la température T_{EF} de 100°C,
   (1) une étape de réalisation d'un assemblage comprenant ce ou ces films adhésifs avec les autres éléments de cet assemblage que sont le ou les composants (opto)électroniques et la ou les couches de protection, ce ou ces films adhésifs étant interposés entre le ou les composants (opto)électroniques et la ou les couches de protection, cette étape (1) étant réalisée à une température T₃ telle que T_{EF} ≤ T₃ < T_{d}, par exemple dans l'intervalle de 100°C à 130°C (bornes comprises), et
   (2) une étape de laminage de l'assemblage réalisé à l'étape (1) précédente cette étape (2) étant également réalisée à la température T₃ telle que T_{EF} ≤ T₃ < T_{d}.

Comme décrit ci-avant, la ou les couches de protection peuvent notamment être formées par une ou des couches de renfort mécanique et/ou par un ou des films barrières, tels que des films barrières aux gaz et/ou aux UV.

Suivent plusieurs variantes de mise en œuvre du procédé d'encapsulation, dont celles qui font l'objet des revendications correspondent à l'invention.

Selon une première variante, le procédé peut comprendre les étapes successives suivantes, réalisées dans cet ordre :
(a) chauffe, par exemple par laminage, de chaque film adhésif seul, de préférence entre deux feuilles pelables,
(b) refroidissement par placement, dans une étuve, de chaque film laminé,
(c') maintien de chaque film laminé dans l'étuve à 100°C (T_{EF}) pendant 1h30,
   (1) après retrait éventuel des feuilles pelables, réalisation de l'assemblage couche de protection/film adhésif/composant(s) (opto)électronique(s)/film adhésif/couche de protection, par exemple sur plaque chauffante, et
   (2) laminage de l'assemblage.

Selon une deuxième variante, le procédé peut comprendre les étapes successives suivantes, réalisées dans cet ordre :
(a) chauffe, par exemple par laminage, de chaque bicouche film adhésif/couche de protection,
(b) refroidissement par placement, dans une étuve, de chaque bicouche laminé,
(c') maintien de chaque bicouche laminé dans l'étuve à 100°C (T_{EF}) pendant 1h30,
   (1) réalisation de l'assemblage couche de protection/film adhésif/composant(s) (opto)électronique(s)/film adhésif/couche de protection, par exemple sur plaque chauffante, et
   (2) laminage de l'assemblage.

Dans le cas où les films adhésifs sont des films adhésifs d'Apolhya®Solar Film R333D, les températures appliquées lors des étapes (a), (b), (c'), (1) et (2), et ce pour chacune des deux variantes du procédé, peuvent être les suivantes :
(a) laminage à une température de consigne de 165°C (T₁),
(b) refroidissement par placement dans une étuve à 100°C (T_{EF}),
(c') maintien dans l'étuve à 100°C (T_{EF}) pendant 1h30,
   (1) réalisation de l'assemblage, par exemple sur plaque chauffante avec une température de consigne fixée à 120°C (T₃), et
   (2) laminage de l'assemblage à une température de consigne de 130°C (T₃).

Il est également divulgué un assemblage du type de ceux décrits dans les documents **[3]** et **[4]**, c'est-à-dire comprenant :
- un ensemble d'une pluralité de cellules photovoltaïques choisies parmi des cellules photovoltaïques organiques, des cellules photovoltaïques à pérovskites, des cellules photovoltaïques à base de semi-conducteurs et des cellules photovoltaïques en tandem à base de pérovskites, les cellules photovoltaïques étant disposées côte à côte et reliées électriquement entre elles,
- au moins une couche de protection, et
- au moins un film adhésif interposé entre la pluralité de cellules photovoltaïques et ladite au moins une couche de protection.

Selon l'invention, chaque film adhésif comprend au moins un polymère thermoplastique semi-cristallin présentant un retard à la cristallisation tel que défini ci-dessus, et l'assemblage est obtenu par la mise en œuvre du procédé d'encapsulation tel que défini ci-avant.

Dans une variante plus particulièrement avantageuse, l'assemblage est constitué par :
- un ensemble d'une pluralité de cellules photovoltaïques choisies parmi des cellules photovoltaïques organiques, des cellules photovoltaïques à pérovskites, des cellules photovoltaïques à base de semi-conducteurs et des cellules photovoltaïques en tandem à base de pérovskites, les cellules photovoltaïques étant disposées côte à côte et reliées électriquement entre elles,
- au moins deux films barrières aux gaz et/ou aux UV, et
- au moins deux films adhésifs interposés entre la pluralité de cellules photovoltaïques et les films barrières aux gaz et/ou aux UV.

Les caractéristiques décrites précédemment en liaison avec le procédé de revêtement ou d'encapsulation, notamment les caractéristiques relatives au polymère thermoplastique semi-cristallin particulier tel que défini ci-avant, aux températures T₁, T_{EF} et T₃ de mise en œuvre du procédé de revêtement ou d'encapsulation ainsi qu'aux couches de protection, telles que les films barrières aux gaz et/ou aux UV, sont bien entendu applicables au présent assemblage.

Il est également divulgué un module photovoltaïque comprenant au moins :
- une première couche transparente formant la face avant du module photovoltaïque destinée à recevoir un flux lumineux,
- un assemblage, et
- une deuxième couche formant la face arrière du module photovoltaïque, l'assemblage étant interposé entre les première et deuxième couches.

L'assemblage du module photovoltaïque est un assemblage tel que défini ci-avant, c'est-à-dire un assemblage qui comprend :
- un ensemble d'une pluralité de cellules photovoltaïques choisies parmi des cellules photovoltaïques organiques, des cellules photovoltaïques à pérovskites, des cellules photovoltaïques à base de semi-conducteurs et des cellules photovoltaïques en tandem à base de pérovskites, les cellules photovoltaïques étant disposées côte à côte et reliées électriquement entre elles,
- au moins une couche de protection, et
- au moins un film adhésif interposé entre la pluralité de cellules photovoltaïques et ladite au moins une couche de protection, le ou chaque film adhésif comprenant au moins un polymère thermoplastique semi-cristallin présentant un retard à la cristallisation particulier tel que défini ci-dessus.

Un tel assemblage peut bien entendu être mis en œuvre dans des modules photovoltaïques, comme on le verra ci-après, mais également dans des structures du type routes solaires. En effet, de telles structures requièrent l'assemblage d'un grand nombre de couches, de nature, d'épaisseur et de propriétés mécaniques variées.

Or, le fait de diminuer la température de mise en œuvre lors du revêtement ou de l'encapsulation des cellules photovoltaïques permet de minimiser les contraintes au sein de l'empilement des couches, favorisant la qualité de l'assemblage et, ainsi, sa durée de vie.

L'invention se rapporte également à un procédé de fabrication d'un module photovoltaïque tel que défini dans la revendication 15.

D'autres caractéristiques et avantages de l'invention apparaîtront mieux à la lecture du complément de description qui suit et qui se rapporte à des procédés d'encapsulation, dont l'un conforme au procédé selon l'invention.

Il est précisé que ce complément de description n'est donné qu'à titre d'illustration de l'objet de l'invention et ne constitue en aucun cas une limitation de cet objet.

### BRÈVE DESCRIPTION DES DESSINS

La figure 1 illustre l'évolution du flux de chaleur (noté φ et exprimé en W/g) en fonction de la température (notée T et exprimée en °C), en première chauffe puis en refroidissement, de films adhésifs d'Apolhya®Solar Film R333D tel qu'obtenu par DSC pour des rampes de chauffe et de refroidissement identiques de 10°C/min, la chauffe apparaissant dans la partie inférieure de la figure entre les températures limites de l'essai et le refroidissement dans la partie supérieure de la figure entre ces mêmes températures limites.
La figure 2 illustre l'évolution du flux de chaleur (noté φ et exprimé en W/g) en fonction de la température (notée T et exprimée en °C), en première chauffe, puis en refroidissement partiel et enfin en deuxième chauffe, de films adhésifs d'Apolhya®Solar Film R333D tel qu'obtenu par DSC pour des rampes de chauffe et de refroidissement identiques de 10°C/min.

Il est à noter que ces figures 1 et 2 ont été commentées précédemment.

### EXPOSÉ DÉTAILLÉ DE MODES DE RÉALISATION PARTICULIERS

Deux séries d'assemblages, notées A et B, présentant la structure ci-dessous ont été réalisées par la mise en œuvre de deux procédés d'encapsulation distincts, l'un étant un procédé conforme au procédé d'encapsulation selon l'invention et l'autre étant un procédé dit "de référence" :
film barrière / film adhésif / film adhésif / film barrière

Les matériaux utilisés pour ces différents films sont les suivants :
- pour chaque film adhésif : un film de 100 µm d'épaisseur de référence commerciale Apolhya®Solar Film R333D de la Société Arkema France,
- pour chaque film barrière de l'assemblage A : un film de 80 µm d'épaisseur de référence commerciale VX-25T-2PO de la Société Oïke, et
- pour chaque film barrière de l'assemblage B : un film de 210 µm d'épaisseur de référence commerciale UBF510 de la Société 3M.

Le procédé d'encapsulation selon l'invention a été réalisé par la mise en œuvre des étapes successives suivantes :
(a) chauffe par laminage, réalisé dans un laminateur à 165°C (T₁) et sous une pression absolue de 10⁵ Pa, de bicouches film adhésif/film barrière :
   - Apolhya®Solar Film R333D/VX-25T-2PO (en vue de l'assemblage A)
   - Apolhya®Solar Film R333D/UBF510 (en vue de l'assemblage B)
(b) refroidissement des bicouches laminés par placement, en sortie du laminateur, dans une étuve à 100°C (T_{EF}),
(c') maintien des bicouches laminés dans l'étuve à 100°C (T_{EF}) pendant 1h30,
   (1) réalisation des assemblages A et B sur plaque chauffante à 120°C (T₃), et
   (2) laminage, réalisé dans un laminateur à 130°C (T₃) et sous une pression absolue de 10⁵ Pa, des assemblages A et B.

Le procédé d'encapsulation de référence a, quant à lui, été réalisé par la mise en œuvre des deux seules étapes successives suivantes :
(1) réalisation des assemblages A et B sur plaque chauffante à 120°C (T₃), et
(2) laminage, réalisé à 130°C (T₃) et sous une pression absolue de 10⁵ Pa, des assemblages A et B.

Des tests de pelage ont été conduits pour évaluer la force de pelage, c'est-à-dire la force moyenne qu'il est nécessaire d'appliquer pour séparer les films barrières du film adhésif et ce, pour chacun des assemblages A et B réalisés selon les procédés de l'invention et de référence.

Ces tests de pelage ont été conduits sur un banc de traction (Instron 3365), muni d'un capteur de force de capacité maximale de 50 N. Les films barrières de chaque assemblage A et B ont été placés, à 180° (pelage en T) dans les mors du banc de traction et le pelage a été effectué à une vitesse de déplacement de la traverse de 300 mm/min.

Les valeurs des forces de pelage (en N/cm) ainsi obtenues sont reportées dans le tableau 1 ci-dessous, tableau qui précise par ailleurs l'aspect visuel de chaque rupture, après pelage de l'assemblage :

**Tableau 1**

| | Force de pelage (en N/cm) | |
|---|---|---|
| Assemblage | Procédé d'encapsulation selon l'invention | Procédé d'encapsulation de référence |
| Assemblage A | 0,62 rupture cohésive puis adhésive | 0,06 rupture adhésive |
| Assemblage B | 9,47 rupture intra-barrière | 4,58 rupture adhésive |

Par rapport au procédé d'encapsulation de référence, le procédé d'encapsulation selon l'invention permet d'obtenir des assemblages A et B présentant une adhésion entre les films barrière et adhésif améliorée, dans le sens où les forces de pelage nécessaires pour obtenir une rupture sont supérieures.

On observe aussi que les modes de rupture sont différents, la rupture ne se produisant plus systématiquement au niveau de l'interface entre le film barrière et le film adhésif des assemblages A et B réalisés par le procédé d'encapsulation selon l'invention :
- dans le cas de l'assemblage A, la rupture est d'abord cohésive (elle se produit au sein du film adhésif) avant d'être adhésive (elle se poursuit à l'interface du film barrière et du film adhésif), et
- dans le cas de l'assemblage B, la rupture se produit au sein du film barrière (rupture intra-barrière).

De tels résultats de pelage sont tout à fait transposables à des assemblages du type des assemblages A et B réalisés ci-dessus mais comprenant, en outre, un ou plusieurs composants (opto)électroniques interposés entre les deux films adhésifs.

### BIBLIOGRAPHIE

**[1]** US 2011/0036623 A1
**[2]** L. La Notte et al., Surface & Coatings Technology, 2014, 255, p. 69-73
**[3]** F. Yan et al., Solar Energy Materials & Solar Cells, 2013, 114, p. 214-218
**[4]** H.C. Weerasinghe et al., Solar Energy Materials & Solar Cells, 2016, 155, p. 108-116
**[5]** US 2011/0091707 A1

## Revendications

1. Procédé de revêtement ou d'encapsulation d'au moins un composant électronique ou optoélectronique par au moins une couche de protection, le ou les composants électroniques ou optoélectroniques se dégradant à partir d'une température T_{d}, le procédé comprenant :
(1) une étape de réalisation d'un assemblage comprenant le ou les composants électroniques ou optoélectroniques, la ou les couches de protection et un ou des films adhésifs interposés entre le ou les composants électroniques ou optoélectroniques et la ou les couches de protection, le ou chaque film adhésif comprenant au moins un polymère thermoplastique semi-cristallin P présentant un retard à la cristallisation et une température de fusion T_{f1}, le polymère thermoplastique semi-cristallin P étant un polymère greffé polyamide comprenant un tronc en polyoléfine, représentant de 50% à 95% en masse du polymère greffé polyamide, un reste d'au moins un monomère insaturé (X) et au moins un greffon en polyamide, le reste d'au moins un monomère insaturé (X) et le ou les greffons en polyamide représentant de 5% à 50% en masse dudit polymère greffé polyamide, dans lequel :
- le ou les greffons en polyamide sont attachés au tronc en polyoléfine par le reste d'au moins un monomère insaturé (X) comprenant une fonction capable de réagir par une réaction de condensation avec un polyamide ayant au moins une extrémité amine et/ou au moins une extrémité acide carboxylique,
- le reste d'au moins un monomère insaturé (X) est fixé sur le tronc par greffage ou copolymérisation,
- le tronc en polyoléfine et le ou les greffons en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du ou des greffons en polyamide et du tronc en polyoléfine, puis
(2) une étape de laminage de l'assemblage réalisé à l'étape (1), **caractérisé en ce que** le procédé comprend, en outre :
(a) une étape de chauffe du ou de chaque film adhésif à une température T₁ telle que T_{f1} < T₁, T₁ étant comprise entre 150°C et 175°C,
(b) une étape de refroidissement du ou de chaque film adhésif chauffé à l'étape (a), de la température T₁ à une température T_{EF} telle que T_{EF} ≤ T_{f1} et T_{EF} < T_{d}, T_{EF} étant comprise entre 95°C et 120°C, et
(c') une étape de maintien du ou de chaque film adhésif refroidi à la température T_{EF},
les étapes (a), (b) et (c'), pendant lesquelles le polymère thermoplastique semi-cristallin P conserve un état fondu, étant mises en œuvre préalablement à l'étape (1), l'étape (1) étant réalisée à une température T₃ et l'étape (2) étant réalisée à une température T_{3'} telles que T_{EF} < T₃ ≤ T_{3'} < T_{d}, T₃ et T_{3'} étant comprises entre 100°C et 130°C.

2. Procédé selon la revendication 1, dans lequel:
- la polyoléfine est choisie parmi le polypropylène, le polyéthylène, les copolymères d'éthylène et de propylène et les copolymères d'éthylène avec des monomères acryliques ou vinyliques ;
- le monomère insaturé (X) est choisi parmi l'anhydride maléique, l'anhydride itaconique, l'anhydride citraconique et l'anhydride allylsuccinique ; et/ou
- le polyamide est choisi parmi les homopolyamides, les copolyamides et leurs mélanges, en particulier parmi les homopolyamides et les copolyamides à une seule terminaison amine.

3. Procédé selon la revendication 1 ou 2, dans lequel T₁ est comprise entre 160°C et 170°C.

4. Procédé selon l'une quelconque des revendications 1 à 3, dans lequel T_{EF} est comprise entre 100°C et 110°C.

5. Procédé selon l'une quelconque des revendications 1 à 4, dans lequel T₃ et T_{3'} sont comprises entre 110°C et 120°C.

6. Procédé selon l'une quelconque des revendications 1 à 5, dans lequel l'étape (a) de chauffe est réalisée par laminage, avantageusement par un laminage réalisé sous une pression absolue comprise entre 10 Pa et 10⁵ Pa.

7. Procédé selon la revendication 6, dans lequel, lors de l'étape (a), le ou chaque film adhésif est laminé seul, le cas échéant, entre deux feuilles pelables, par exemple en polytétrafluoroéthylène (PTFE).

8. Procédé selon la revendication 7, dans lequel, lors de l'étape (1), on dispose, après retrait des feuilles pelables, le ou chaque film adhésif laminé de part et d'autre du ou des composants (opto)électroniques, puis la ou chaque couche de protection sur chaque film adhésif.

9. Procédé selon la revendication 6, dans lequel, lors de l'étape (a), on procède au laminage d'un ou de bicouches, le ou chaque bicouche étant constitué d'un film adhésif et d'une couche de protection.

10. Procédé selon la revendication 9, dans lequel, lors de l'étape (1), on dispose le ou chaque bicouche de part et d'autre du ou des composants électroniques ou optoélectroniques de telle sorte que le ou chaque film adhésif du ou des bicouches soit en contact avec le ou les composants électroniques ou optoélectroniques.

11. Procédé selon l'une quelconque des revendications 1 à 10, dans lequel le laminage de l'étape (2) est réalisé sous une pression absolue comprise entre 10 Pa et 10⁵ Pa.

12. Procédé selon l'une quelconque des revendications 1 à 11, dans lequel l'épaisseur du ou de chaque film adhésif est inférieure ou égale à 500 µm et, avantageusement, comprise entre 50 µm et 200 µm.

13. Procédé selon l'une quelconque des revendications 1 à 12, dans lequel la ou chaque couche de protection est formée par un film barrière, l'épaisseur du ou de chaque film barrière étant avantageusement inférieure ou égale à 500 µm et, préférentiellement, comprise entre 50 µm et 250 µm.

14. Procédé selon l'une quelconque des revendications 1 à 13, dans lequel ledit au moins un composant électronique ou optoélectronique est une diode électroluminescente organique (OLED), une diode électroluminescente à polymère (PLED), un photo-détecteur organique, un transistor organique tel qu'un transistor à couches minces organiques (OTFT), ou une cellule photovoltaïque telle qu'une cellule photovoltaïque organique, une cellule photovoltaïque à pérovskites, une cellule photovoltaïque à base de semi-conducteurs ou une cellule photovoltaïque en tandem à base de pérovskites, par exemple une cellule photovoltaïque en tandem silicium/pérovskite.

15. Procédé de fabrication d'un module photovoltaïque comprenant au moins :
- une première couche transparente formant la face avant du module photovoltaïque destinée à recevoir un flux lumineux,
- un assemblage, et
- une deuxième couche formant la face arrière du module
photovoltaïque,
l'assemblage étant interposé entre les première et deuxième couches, ledit procédé comprenant :
- une première étape de revêtement ou d'encapsulation par la mise en œuvre du procédé selon l'une quelconque des revendications 1 à 14 pour former l'assemblage comprenant :
• un ensemble d'une pluralité de cellules photovoltaïques choisies parmi des cellules photovoltaïques organiques, des cellules photovoltaïques à pérovskites, des cellules photovoltaïques à base de semi-conducteurs et des cellules photovoltaïques en tandem à base de pérovskites, les cellules photovoltaïques étant disposées côte à côte et reliées électriquement entre elles,
• au moins une couche de protection, avantageusement deux films barrières aux gaz et/ou aux UV, et
• au moins un film adhésif interposé entre la pluralité de cellules photovoltaïques et ladite au moins une couche de protection, avantageusement deux films barrières aux gaz et/ou aux UV, le ou chaque film adhésif comprenant au moins le polymère thermoplastique semi-cristallin P, et
- une deuxième étape de laminage à une température comprise entre la température ambiante et T_{d} de l'ensemble comprenant la première couche, l'assemblage et la deuxième couche formant le module photovoltaïque.

## Patentansprüche

1. Verfahren zur Beschichtung oder zur Einkapselung wenigstens einer elektronischen oder optoelektronischen Komponente mittels wenigstens einer Schutzschicht, wobei die elektronische(n) oder optoelektronische(n) Komponente(n) sich ab einer Temperatur T_{d} verschlechtert, wobei das Verfahren umfasst:
(1) einen Schritt der Herstellung einer Anordnung, umfassend die elektronische(n) oder optoelektronische(n) Komponente(n), die Schutzschicht(en) und einen oder mehrere Haftfilme, eingefügt zwischen der oder den elektronischen oder optoelektronischen Komponente(n) und der oder den Schutzschichten, wobei der oder jeder Haftfilm wenigstens ein semikristallines thermoplastisches Polymer P umfasst, das eine Verzögerung bei der Kristallisation und eine Schmelztemperatur T_{f1} aufweist, wobei das semikristalline thermoplastische Polymer P ein gepfropftes Polyamidpolymer ist, das einen Stamm aus Polyolefin umfasst, der von 50 bis 95 Massen-% des gepfropften Polyamidpolymers repräsentiert, einen Rest aus wenigstens einem ungesättigten Monomer (X) und wenigstens einen Pfröpfling aus Polyamid, wobei der Rest aus wenigstens einem ungesättigten Monomer (X) und der oder die Polyamidpfröpflinge von 5 bis 50 Massen-% des gepfropften Polyamidpolymers repräsentieren, wobei:
- der oder die Pfröpflinge aus Polyamid an dem Stamm aus Polyolefin mittels des Rests aus wenigstens einem ungesättigten Monomer (X) angebracht sind, umfassend eine Funktion, die in der Lage ist, mittels einer Kondensationsreaktion mit einem Polyamid zu reagieren, das wenigstens ein Aminende und/oder wenigstens ein Karbonsäureende hat,
- der Rest aus wenigstens einem ungesättigten Monomer (X) an dem Stamm mittels Pfropfen oder Copolymerisation befestigt ist,
- der Stamm aus Polyolefin und der oder die Pfröpflinge aus Polyamid derart ausgewählt sind, dass das gepfropfte Polyamidpolymer eine Fließtemperatur größer oder gleich 75°C und kleiner oder gleich 160°C aufweist, wobei diese Fließtemperatur definiert ist als die höchste Temperatur aus den Schmelztemperaturen und den Glasübergangstemperaturen des oder der Pfröpflinge aus Polyamid und des Stamms aus Polyolefin, dann
(2) einen Schritt des Laminierens der im Schritt (1) hergestellten Anordnung,
**dadurch gekennzeichnet, dass** das Verfahren ferner umfasst:
(a) einen Schritt des Erhitzens des oder jedes Haftfilms auf eine Temperatur T₁ derart, dass T_{f1} < T₁, wobei T₁ zwischen 150°C und 175°C enthalten ist,
(b) einen Schritt des Abkühlens des oder jedes im Schritt (a) erhitzten Haftfilms von der Temperatur T₁ auf eine Temperatur T_{EF} derart, dass T_{EF} ≤ T_{f1} und T_{EF} < T_{d}, wobei T_{EF} zwischen 95°C und 120°C enthalten ist, und
(c') einen Schritt des Haltens des oder jedes abgekühlten Haftfilms auf der Temperatur T_{EF},
wobei die Schritte (a), (b) und (c'), während derer das semikristalline thermoplastische Polymer P einen geschmolzenen Zustand beibehält, vor dem Schritt (1) durchgeführt werden, wobei der Schritt (1) bei einer Temperatur T₃ durchgeführt wird, und der Schritt (2) bei einer Temperatur T_{3'} durchgeführt wird, derart, dass T_{EF} < T₃ ≤ T_{3'} < T_{d}, wobei T₃ und T_{3'} zwischen 100°C und 130°C enthalten sind.

2. Verfahren nach Anspruch 1, bei dem:
- das Polyolefin ausgewählt ist aus Polypropylen, Polyethylen, den Copolymeren von Ethylen und von Propylen und den Copolymeren von Ethylen mit Acryl- oder Vinylmonomeren;
- das ungesättigte Monomer (X) ausgewählt ist aus Maleinsäureanhydrid, Itakonsäureanhydrid, Citraconsäureanhydrid und Allylbernsteinsäureanhydrid; und/oder
- das Polyamid ausgewählt ist aus den Homopolyamiden, den Copolyamiden und ihren Mischungen, insbesondere aus den Homopolyamiden und den Copolyamiden mit einer einzigen Aminendgruppe.

3. Verfahren nach Anspruch 1 oder 2, bei dem T₁ zwischen 160°C und 170°C enthalten ist.

4. Verfahren nach einem der Ansprüche 1 bis 3, bei dem T_{EF} zwischen 100°C und 110°C enthalten ist.

5. Verfahren nach einem der Ansprüche 1 bis 4, bei dem T₃ und T_{3'} zwischen 110°C und 120°C enthalten sind.

6. Verfahren nach einem der Ansprüche 1 bis 5, bei dem der Schritt (a) des Erhitzens durch Laminieren realisiert wird, vorzugsweise durch ein Laminieren, das unter einem absoluten Druck realisiert wird, der zwischen 10 Pa und 10⁵ Pa enthalten ist.

7. Verfahren nach Anspruch 6, bei dem während des Schritts (a) der oder jeder Haftfilm gegebenenfalls alleine zwischen zwei abziehbaren Lagen laminiert wird, beispielsweise aus Polytetrafluorethylen (PTFE).

8. Verfahren nach Anspruch 7, bei dem man während des Schritts (1) nach dem Entfernen der abziehbaren Lagen den oder jeden laminierten Haftfilm auf beiden Seiten der (opto)elektronischen Komponente(n) anordnet, und dann die oder jede Schutzschicht auf jedem Haftfilm.

9. Verfahren nach Anspruch 6, bei dem man während des Schritts (a) eine Laminierung von einer oder mehreren Doppelschichten vornimmt, wobei die oder jede Doppelschicht durch einen Haftfilm und eine Schutzschicht gebildet ist.

10. Verfahren nach Anspruch 9, bei dem man während des Schritts (1) die oder jede Doppelschicht auf beiden Seiten der elektronischen oder optoelektronischen Komponente(n) derart anordnet, dass der oder jeder Haftfilm der Doppelschicht(en) in Kontakt ist mit der oder den elektronischen oder optoelektronischen Komponenten.

11. Verfahren nach einem der Ansprüche 1 bis 10, bei dem die Laminierung des Schritts (2) unter einem absoluten Druck realisiert wird, der zwischen 10 Pa und 10⁵ Pa enthalten ist.

12. Verfahren nach einem der Ansprüche 1 bis 11, bei dem die Dicke des oder jedes Haftfilms kleiner oder gleich 500 µm ist, und vorzugsweise zwischen 50 µm und 200 µm enthalten ist.

13. Verfahren nach einem der Ansprüche 1 bis 12, bei dem die oder jede Schutzschicht durch einen Barrierefilm gebildet ist, wobei die Dicke des oder jedes Barrierefilms vorzugsweise kleiner oder gleich 500 µm ist, und bevorzugt zwischen 50 µm und 250 µm enthalten ist.

14. Verfahren nach einem der Ansprüche 1 bis 13, bei dem die wenigstens eine elektronische oder optoelektronische Komponente eine organische Leuchtdiode (OLED), eine Polymer-Leuchtdiode (PLED), ein organischer Photodetektor, ein organischer Transistor wie zum Beispiel ein organischer Dünnschichttransistor (OTFT) oder eine photovoltaische Zelle wie zum Beispiel eine organische photovoltaische Zelle, eine photovoltaische Perovskitzelle, eine photovoltaische Zelle auf Basis von Halbleitern oder eine photovoltaische Tandemzelle auf Basis von Perovskiten ist, beispielsweise eine photovoltaische Silizium/Perovskit-Tandemzelle.

15. Verfahren zur Herstellung eines photovoltaischen Moduls, umfassend wenigstens:
- eine erste transparente Schicht, die die Vorderfläche des photovoltaischen Moduls bildet, und die dazu ausgelegt ist, einen Lichtstrom zu empfangen,
- eine Anordnung, und
- eine zweite Schicht, die die Rückfläche des photovoltaischen Moduls bildet,
wobei die Anordnung zwischen der ersten und der zweiten Schicht eingefügt ist, wobei das Verfahren umfasst:
- einen ersten Schritt der Beschichtung oder der Einkapselung durch Durchführen des Verfahrens nach einem der Ansprüche 1 bis 14, um die Anordnung zu bilden, umfassend:
• eine Anordnung aus einer Mehrzahl von photovoltaischen Zellen, ausgewählt aus den organischen photovoltaischen Zellen, den photovoltaischen Perovskitzellen, den photovoltaischen Zellen auf Basis von Halbleitern und den photovoltaischen Tandemzellen auf Basis von Perovskiten, wobei die photovoltaischen Zellen nebeneinander angeordnet und elektrisch miteinander verbunden sind,
• wenigstens eine Schutzschicht, vorzugsweise zwei Gas- und/oder UV-Barrrierefilme, und
• wenigstens einen Haftfilm, eingefügt zwischen der Mehrzahl von photovoltaischen Zellen und der wenigstens einen Schutzschicht, vorzugsweise zwei Gas- und/oder UV-Barrierefilme, wobei der oder jeder Haftfilm wenigstens das semikristalline thermoplastische Polymer P umfasst, und
- einen zweiten Schritt des Laminierens, bei einer Temperatur, die enthalten ist zwischen der Umgebungstemperatur und T_{d}, der Gesamtheit, die die erste Schicht, die Anordnung und die zweite Schicht enthält, die das photovoltaische Modul bildet.

## Claims

1. A process for coating or encapsulating at least one electronic or optoelectronic component with at least one protective layer, the electronic or optoelectronic component(s) deteriorating from a temperature T_{d}, the process comprising:
(1) a step of making an assembly comprising the electronic or optoelectronic component(s), the protective layer(s) and an adhesive film or adhesive films interposed between the electronic or optoelectronic component(s) and the protective layer(s), the or each adhesive film comprising at least one semi-crystalline thermoplastic polymer P having a delay in the crystallisation and a melting temperature T_{f1}, the semi-crystalline thermoplastic polymer P being a polyamide-grafted polymer comprising a polyolefin backbone, accounting for 50% to 95% by mass of the polyamide-grafted polymer, a residue of at least one unsaturated monomer (X) and at least one polyamide graft, the residue of at least one unsaturated monomer (X) and the polyamide graft(s) accounting for 5% to 50% by mass of said polyamide-grafted polymer, wherein:
- the polyamide graft(s) is/are attached to the polyolefin backbone by the residue of at least one unsaturated monomer (X) comprising a function capable of reacting by a condensation reaction with a polyamide having at least one amine end and/or at least one carboxylic acid end,
the residue of at least one unsaturated monomer (X) is attached to the backbone by grafting or copolymerisation,
the polyolefin backbone and the polyamide graft(s) being selected so that said polyamide-grafted polymer has a flow temperature greater than or equal to 75°C and lower than or equal to 160°C, this flow temperature being defined as the highest temperature among the melting temperatures and the glass transition temperatures of the polyamide graft(s) and of the polyolefin backbone, and then
(2) a step of laminating the assembly made in step (1),
**characterised in that** the process further comprises:
(a) a step of heating the or each adhesive film at a temperature T₁ such that T_{f1} < T₁, T₁ being between 150°C and 175°C,
(b) a step of cooling the or each adhesive film heated in step (a), from temperature T₁ to a temperature T_{EF} such that T_{EF} ≤T_{f1} and T_{EF} < T_{d}, T_{EF} being between 95°C and 120°C, and
(c') a step of maintaining the or each adhesive film cooled to temperature T_{EF}, steps (a), (b) and (c'), during which the semi-crystalline thermoplastic polymer P keeps a molten state, being implemented prior to step (1), step (1) being performed at a temperature T₃ and step (2) being performed at a temperature T_{3'} such that T_{EF} < T₃ ≤ T_{3'} < T_{d}, T₃ and T_{3'} being between 100°C and 130°C.

2. The process according to claim 1, wherein:
- the polyolefin is selected from polypropylene, polyethylene, ethylene and propylene copolymers and copolymers of ethylene with acrylic or vinyl monomers;
- the unsaturated monomer (X) is selected from maleic anhydride, itaconic anhydride, citraconic anhydride and allylsuccinic anhydride; and/or
- the polyamide is selected from homopolyamides, copolyamides and mixtures thereof, in particular from homopolyamides and copolyamides with a single amine termination.

3. The process according to claim 1 or 2, wherein T₁ is between 160°C and 170°C.

4. The process according to any of claims 1 to 3, wherein T_{EF} is between 100°C and 110°C.

5. The process according to any of claims 1 to 4, wherein T₃ and T_{3'} are between 110°C and 120°C.

6. The process according to any of claims 1 to 5, wherein the heating step (a) is performed by lamination, advantageously by a lamination performed under an absolute pressure between 10 Pa and 10⁵ Pa.

7. The process according to claim 6, wherein, during step (a), the or each adhesive film is laminated alone, where appropriate, between two peelable sheets, for example of polytetrafluoroethylene (PTFE).

8. The process according to claim 7, wherein, during step (1), after withdrawing the peelable sheets, the or each laminated adhesive film is disposed on either side of the (opto)electronic component(s), and then the or each protective layer is disposed on each adhesive film.

9. The process according to claim 6, wherein, during step (a), laminating one bilayer or bilayers is performed, the or each bilayer consisting of an adhesive film and a protective layer.

10. The process according to claim 9, wherein, during step (1), the or each bilayer is disposed on either side of the electronic or optoelectronic component(s) so that the or each adhesive film of the bilayer(s) is in contact with the electronic or optoelectronic component(s).

11. The process according to any of claims 1 to 10, wherein laminating in step (2) is performed under an absolute pressure between 10 Pa and 10⁵ Pa.

12. The process according to any of claims 1 to 11, wherein the thickness of the or each adhesive film is lower than or equal to 500 µm and, advantageously, between 50 µm and 200 µm.

13. The process according to any of claims 1 to 12, wherein the or each protective layer is formed by a barrier film, the thickness of the or each barrier film being advantageously lower than or equal to 500 µm and, preferentially, between 50 µm and 250 µm.

14. The process according to any of claims 1 to 13, wherein said at least one electronic or optoelectronic component is an organic light emitting diode (OLED), a polymer light emitting diode (PLED), an organic photodetector, an organic transistor such as an organic thin film transistor (OTFT), or a photovoltaic cell such as an organic photovoltaic cell, a perovskite photovoltaic cell, a semiconductor-based photovoltaic cell or a perovskite-based tandem photovoltaic cell, for example a silicon/perovskite tandem photovoltaic cell.

15. A process for manufacturing a photovoltaic module comprising at least:
- a first transparent layer forming the front face of the photovoltaic module and intended to receive a luminous flux,
- a assembly, and
- a second layer forming the rear face of the photovoltaic module,
the assembly being interposed between the first and second layers, said process comprising:
- a first coating or encapsulating step by implementing the process according to any of claims 1 to 14 to form the assembly comprising:
• a set of a plurality of photovoltaic cells selected from organic photovoltaic cells, perovskite photovoltaic cells, semiconductor-based photovoltaic cells and perovskite-based tandem photovoltaic cells, the photovoltaic cells being disposed side by side and electrically connected to each other,
• at least one protective layer, advantageously two gas and/or UV barrier films, and
• at least one adhesive film interposed between the plurality of photovoltaic cells and said at least one protective layer, advantageously two gas and/or UV barrier films, the or each adhesive film comprising at least the semi-crystalline thermoplastic polymer P, and
- a second step of laminating, at a temperature between room temperature and T_{d}, the set comprising the first layer, the assembly and the second layer forming the photovoltaic module.
